# EUROPEAN PATENT APPLICATION

(11) **EP 4 783 200 A1**
(43) Date of publication of application: **29.07.2026**
(21) Application number: 24867859.1
(22) Date of filing: 25.06.2024
(51) Int. Cl.: H01F 17/04, H01F 17/06, H01F 27/24, H01F 27/29, H05K 3/46

(54) **ELECTRONIC COMPONENT AND SUBSTRATE WITH BUILT-IN ELECTRONIC COMPONENT**

(30) Priority: 19.09.2023 JP 2023151451
(71) Applicant: TDK Corporation, Tokyo 103-6128 (JP)
(72) Inventor: HIGASHIDA, Keigo, Tokyo 103-6128 (JP); GOSHIMA, Hironari, Tokyo 103-6128 (JP); KURODA, Tomofumi, Tokyo 103-6128 (JP); YOSHIDA, Kenichi, Tokyo 103-6128 (JP); TOMONARI, Toshio, Tokyo 103-6128 (JP)
(74) Representative: Epping - Hermann - Fischer
(86) International application number: PCT/JP2024/022982
(87) International publication number: WO 2025/062773

(57) **Abstract**

To provide an electronic component suitable for incorporation into a substrate. An electronic component 10 includes a magnetic element body 20 and a metal frame 30 embedded in the magnetic element body 20. The metal frame 30 includes substantially parallel sections 31 and 32, a section 33 connecting one end of the section 31 and one end of the section 32, a section 34 connected to the other end of the section 31 and exposed at least partially on the main surface 21 of the magnetic element body 20, and a section 35 connected to the other end of the section 32 and exposed at least partially on the main surface 22 of the magnetic element body 20.

## Description

### [Technical Field]

The present disclosure relates to an electronic component and, more particularly, to an electronic component having a structure in which a coil is embedded in a magnetic element body. The present disclosure also relates to an electronic component-embedded substrate incorporating such an electronic component.

### [Background Art]

Patent Document 1 discloses an inductor having a structure in which a conductor formed by bending a metal sheet is embedded in an element body.

### [Citation List]

### [Patent Document]

[Patent Document 1] JP 2022-151206A

### [Disclosure of the Invention]

### [Problem to be Solved by the Invention]

The inductor disclosed in Patent Document 1 is a surface-mounted electronic component.

The present disclosure describes an electronic component suitable for incorporation into a substrate.

### [Means for Solving the Problem]

An electronic component according to an aspect of the present disclosure includes: a magnetic element body having a first main surface and a second main surface located on the opposite side of the first main surface; and a first metal frame embedded in the magnetic element body, wherein the first metal frame includes: first and second sections facing each other and substantially parallel to each other; a third section connecting one end of the first section and one end of the second section; a fourth section connected to the other end of the first section and exposed at least partially on the first main surface; and a fifth section connected to the other end of the second section and exposed at least partially on the second main surface.

### [Advantageous Effects of the Invention]

According to the present disclosure, an electronic component suitable for incorporation into a substrate is provided.

### [Brief Description of the Drawings]

[FIG. 1]

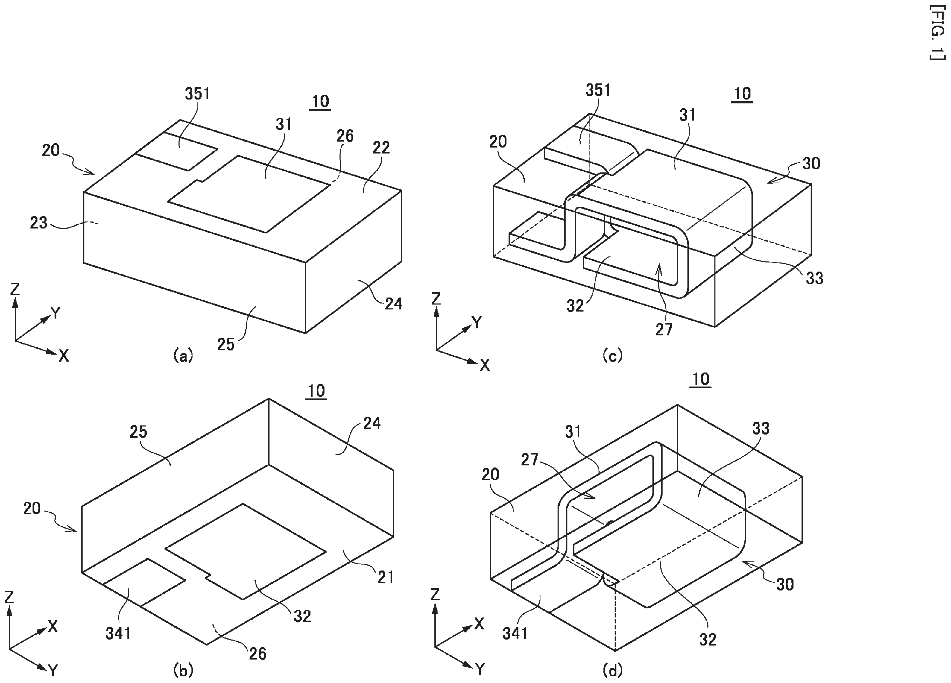

   FIG. 1(a) and 1(b) are schematic perspective views illustrating the external appearance of an electronic component 10 according to a first embodiment of the technology described herein, as seen from different directions. FIGS. 1(c) and 1(d) are schematic perspective views with transparency illustrating the electronic component 10, as seen from different directions.
[FIG. 2]

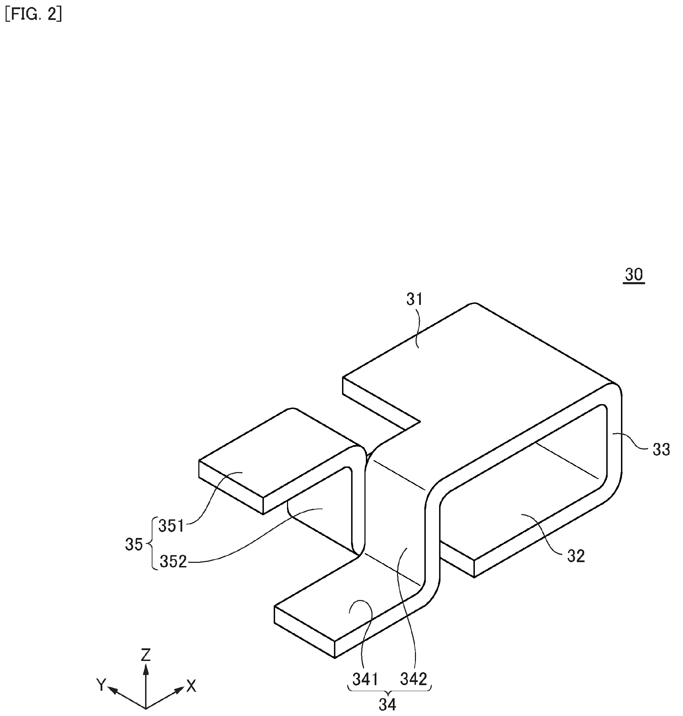

   FIG. 2 is a schematic perspective view for explaining the structure of the metal frame 30.
[FIG. 3]

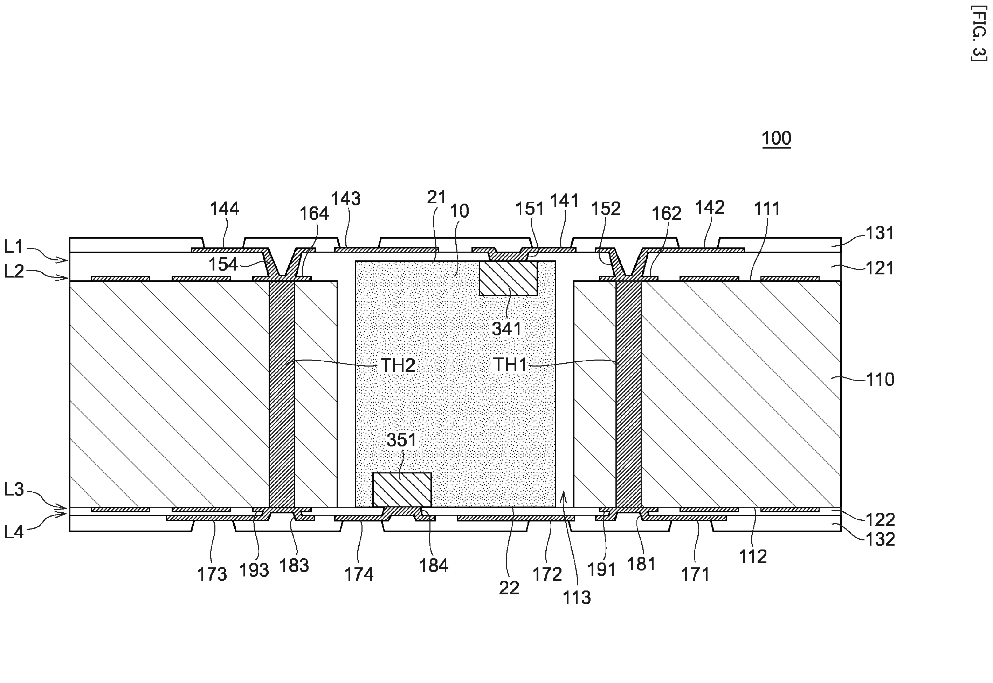

   FIG. 3 is a schematic cross-sectional view of an electronic component-embedded substrate 100 incorporating the electronic component 10.
[FIG. 4]

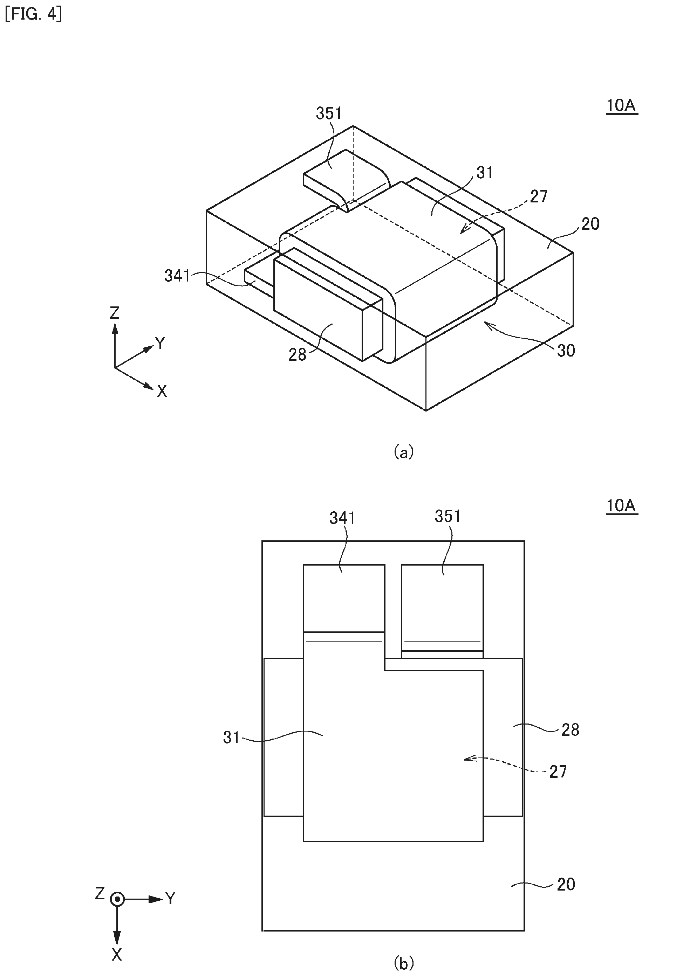

   FIG. 4(a) is a schematic perspective view with transparency illustrating the outer appearance of an electronic component 10A according to a second embodiment of the technology described herein. FIG. 4(b) is a schematic top view with transparency of the electronic component 10A.
[FIG. 5]

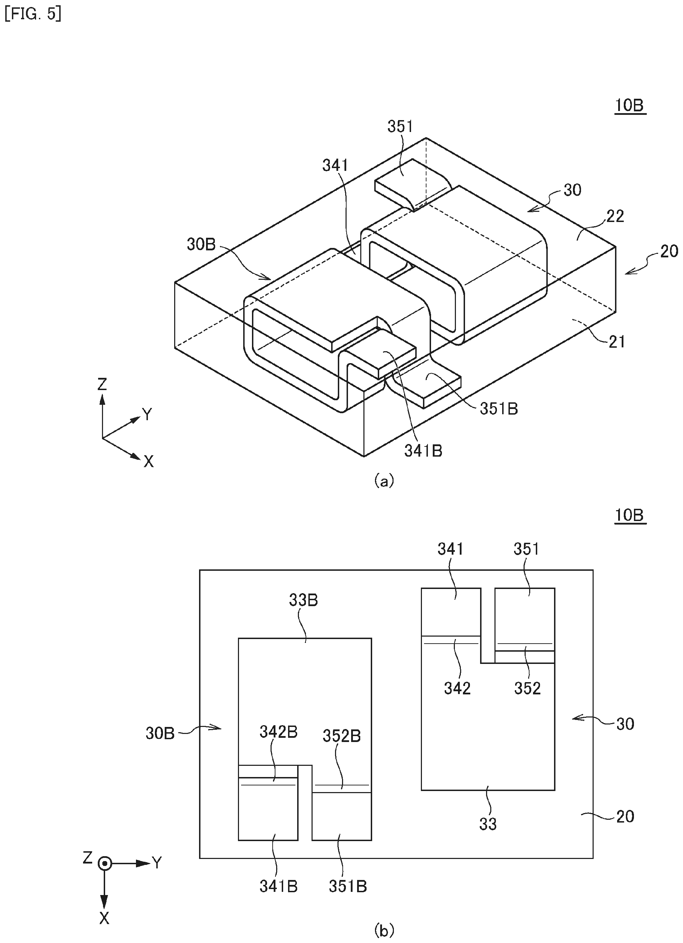

   FIG. 5(a) is a schematic perspective view with transparency illustrating the outer appearance of an electronic component 10B according to a third embodiment of the technology described herein. FIG. 5(b) is a schematic top view with transparency of the electronic component 10B.
[FIG. 6]

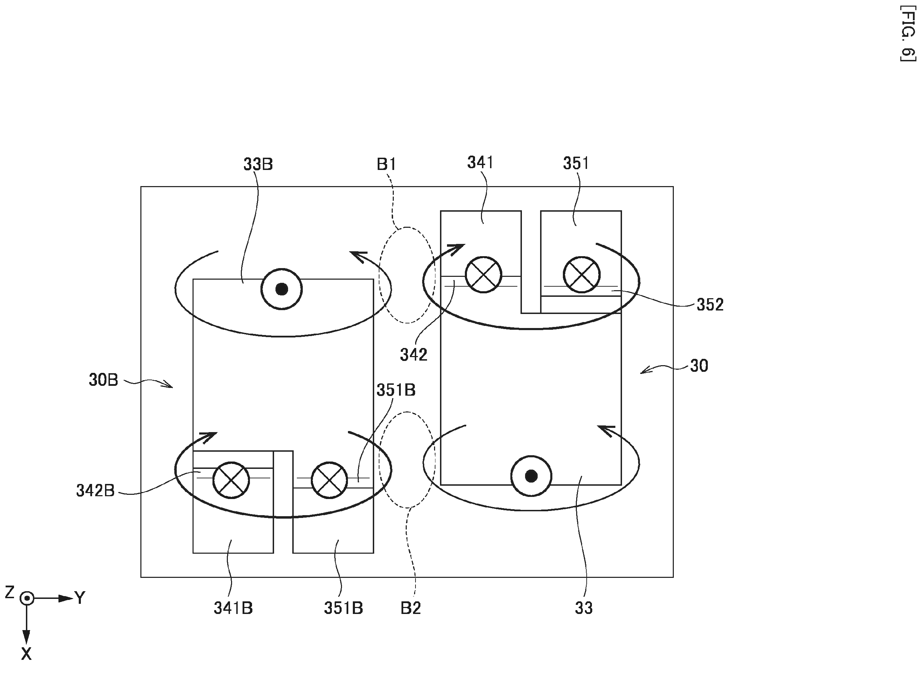

   FIG. 6 is a schematic diagram for explaining the direction of the magnetic field generated by electronic component 10B.
[FIG. 7]

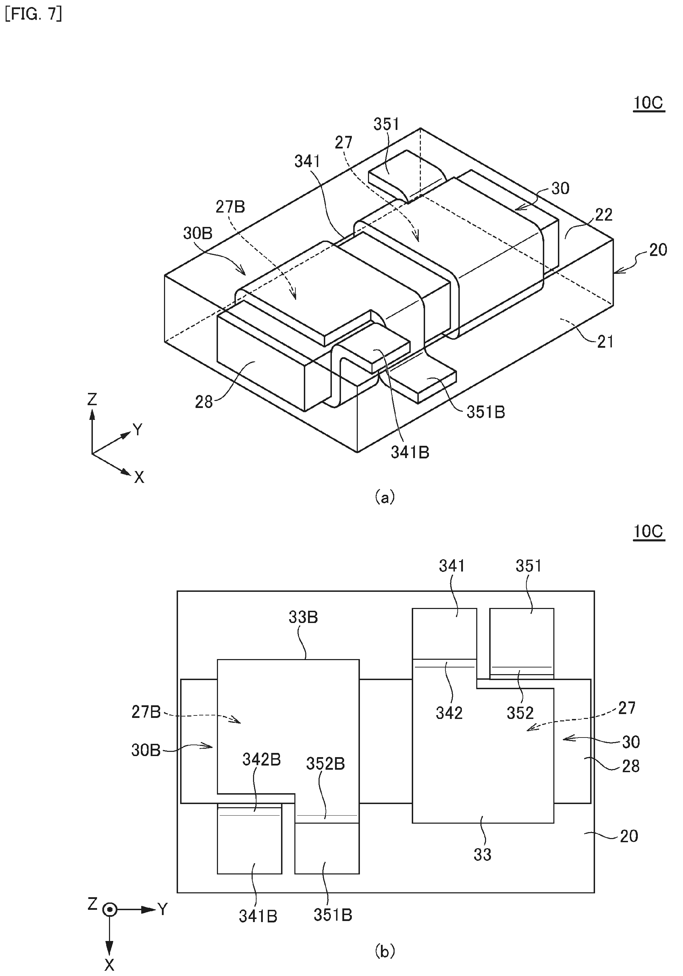

   FIG. 7(a) is a schematic perspective view with transparency illustrating the outer appearance of an electronic component 10C according to a fourth embodiment of the technology described herein. FIG. 7(b) is a schematic top view with transparency of the electronic component 10C.
[FIG. 8]

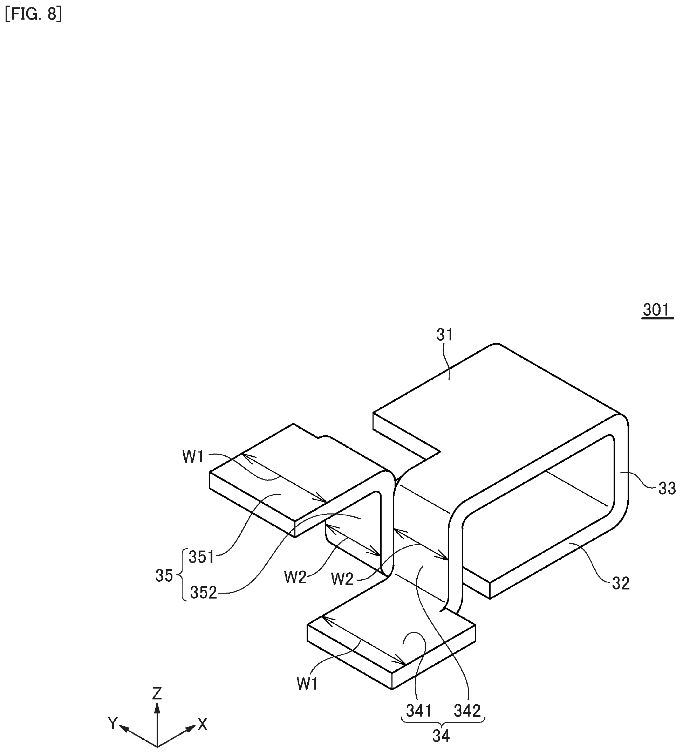

   FIG. 8 is a schematic perspective view for explaining the structure of a metal frame 301 according to a first modification.
[FIG. 9]

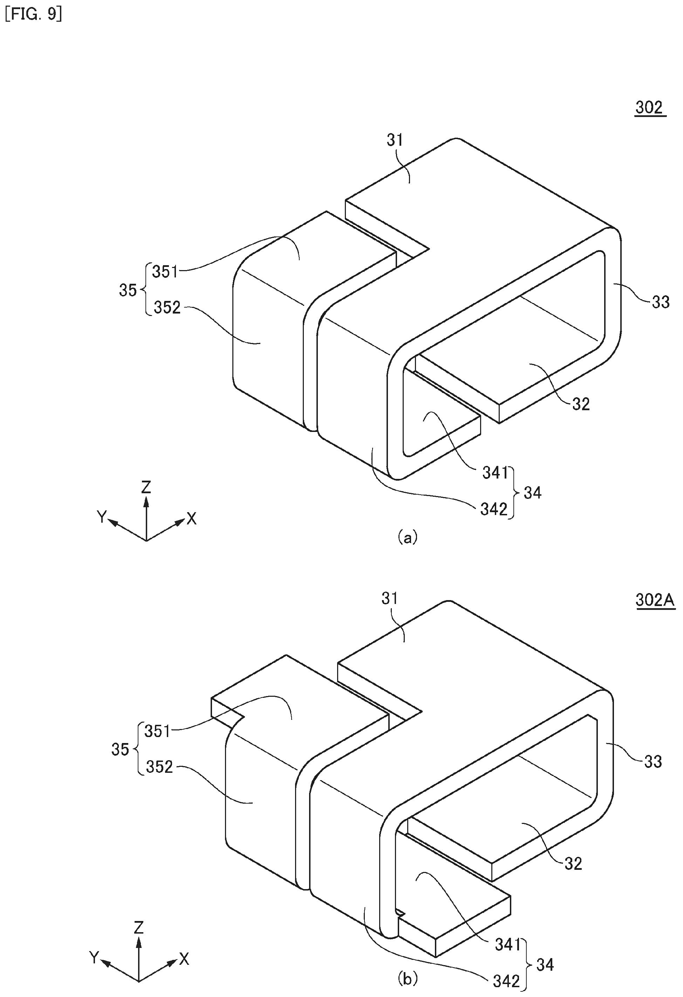

   FIG. 9(a) is a schematic perspective view for explaining the structure of a metal frame 302 according to a second modification. FIG. 9(b) is a schematic perspective view illustrating a metal frame 302 according to a modification.
[FIG. 10]

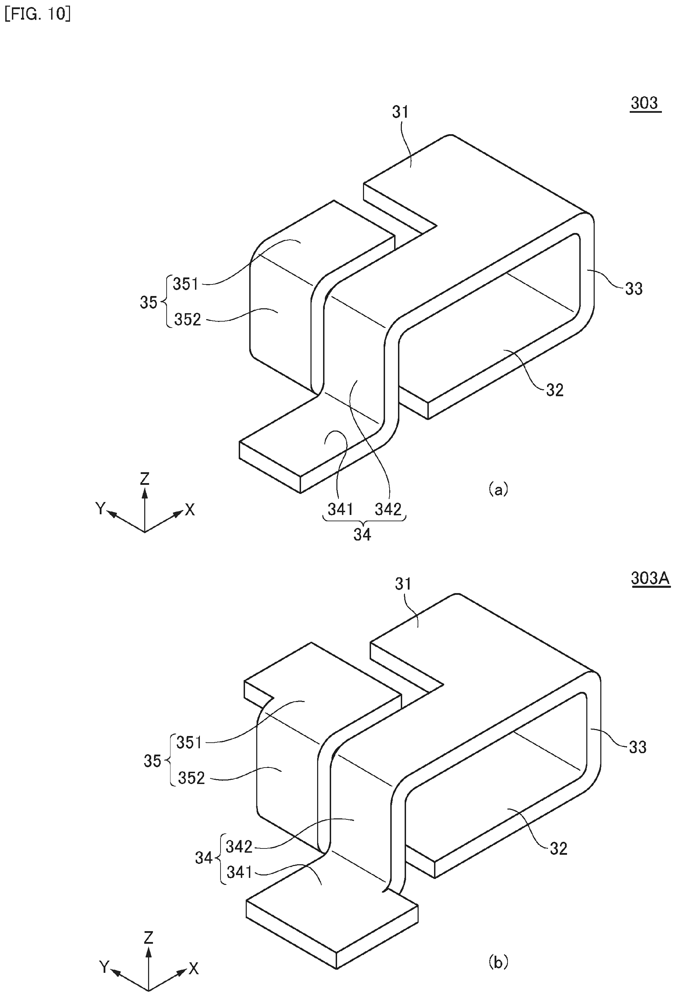

   FIG. 10(a) is a schematic perspective view for explaining the structure of a metal frame 303 according to a third modification. FIG. 10(b) is a schematic perspective view illustrating a metal frame 303 according to a modification.
[FIG. 11]

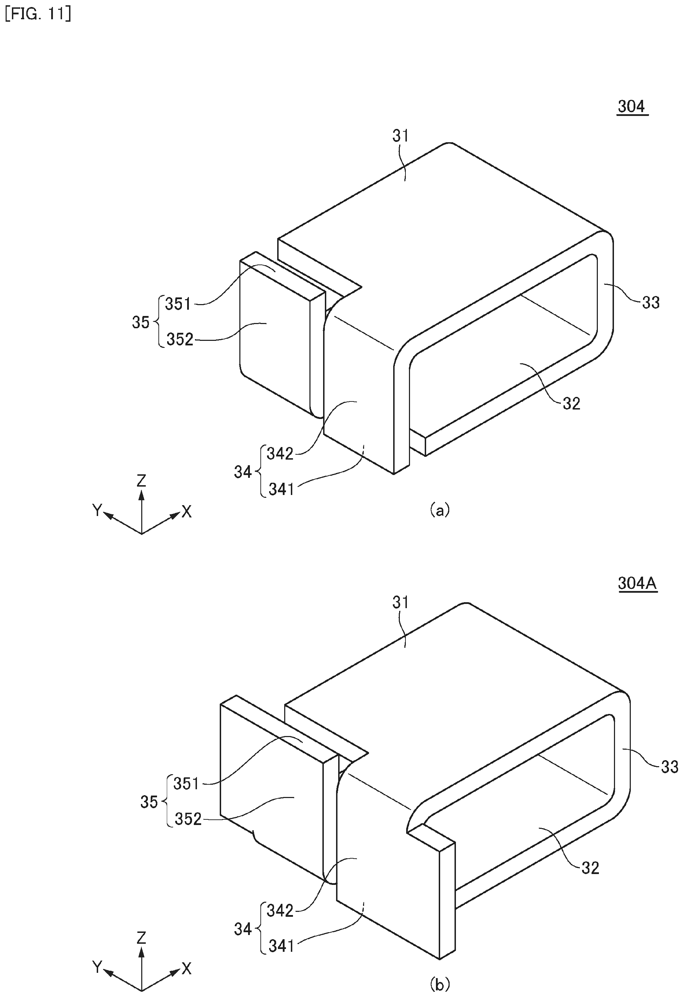

   FIG. 11(a) is a schematic perspective view for explaining the structure of a metal frame 304 according to a fourth modification. FIG. 11(b) is a schematic perspective view illustrating a metal frame 304 according to a modification.
[FIG. 12]

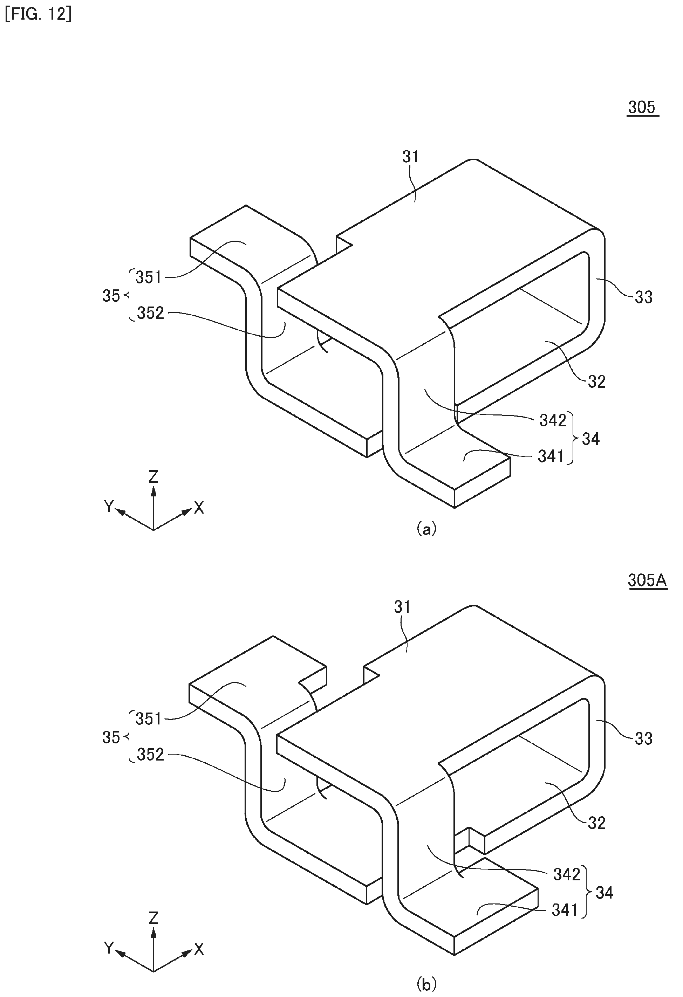

   FIG. 12(a) is a schematic perspective view for explaining the structure of a metal frame 305 according to a fifth modification. FIG. 12(b) is a schematic perspective view illustrating a metal frame 305 according to a modification.
[FIG. 13]

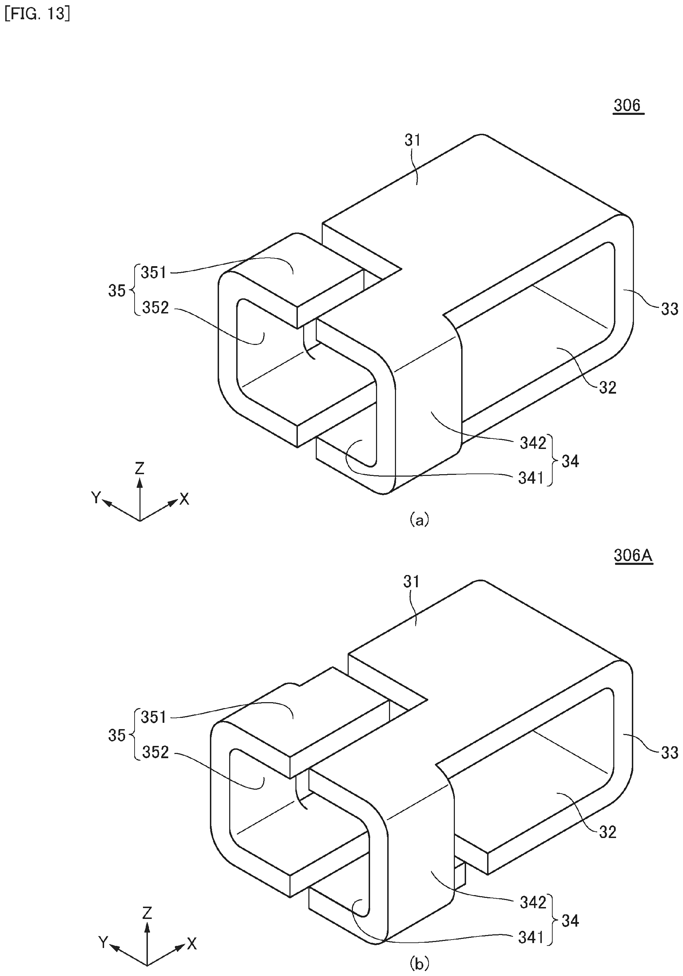

   FIG. 13(a) is a schematic perspective view for explaining the structure of a metal frame 306 according to a sixth modification. FIG. 13(b) is a schematic perspective view illustrating a metal frame 306 according to a modification.
[FIG. 14]

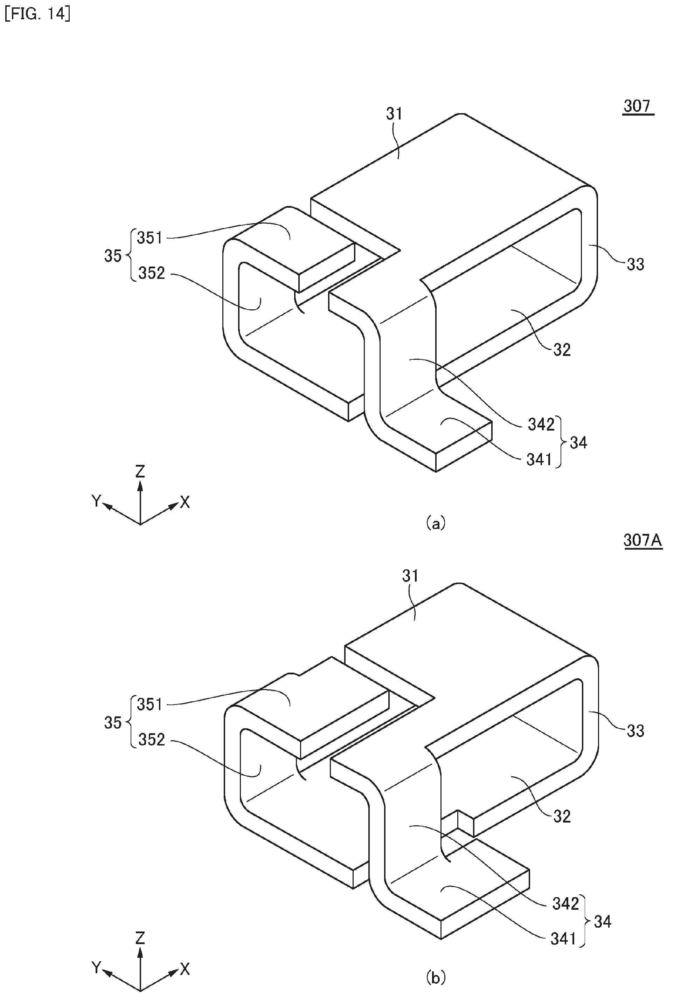

   FIG. 14(a) is a schematic perspective view for explaining the structure of a metal frame 307 according to a seventh modification. FIG. 14(b) is a schematic perspective view illustrating a metal frame 307 according to a modification.
[FIG. 15]

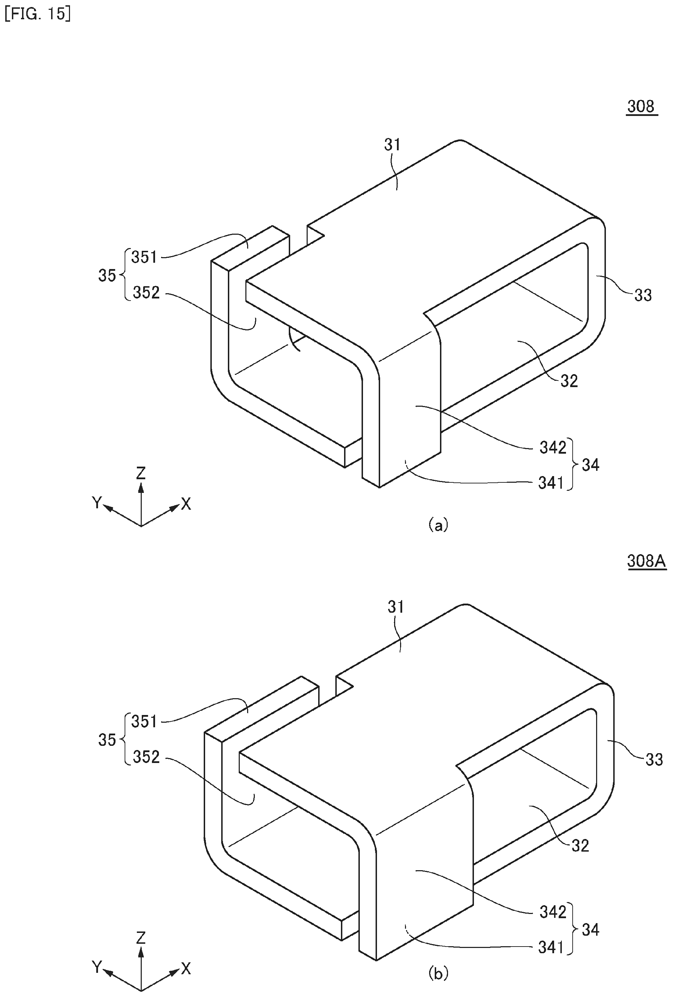

   FIG. 15(a) is a schematic perspective view for explaining the structure of a metal frame 308 according to an eighth modification. FIG. 15(b) is a schematic perspective view illustrating a metal frame 308 according to a modification.
[FIG. 16]

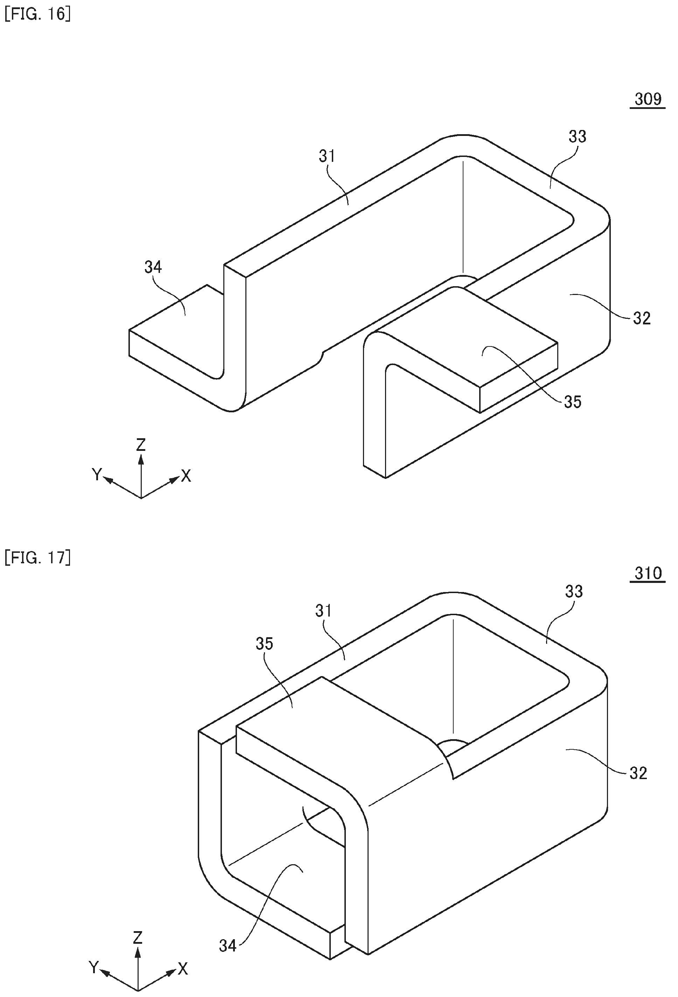

   FIG. 16 is a schematic perspective view for explaining the structure of a metal frame 309 according to a ninth modification.
[FIG. 17]
   FIG. 17 is a schematic perspective view for explaining the structure of a metal frame 310 according to a tenth modification.
[FIG. 18]

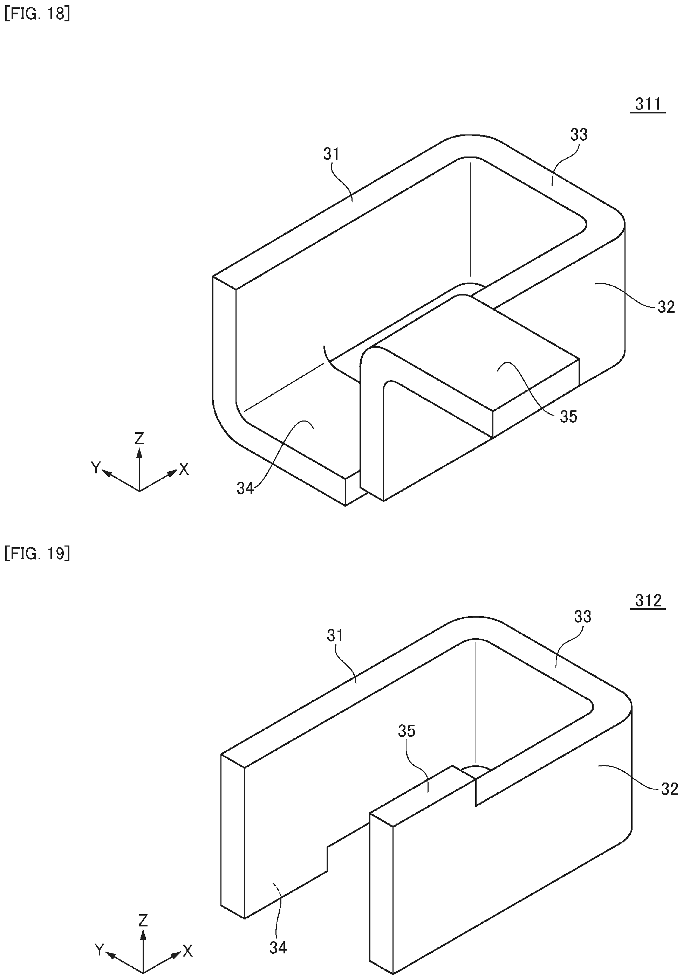

   FIG. 18 is a schematic perspective view for explaining the structure of a metal frame 311 according to an eleventh modification.
[FIG. 19]
   FIG. 19 is a schematic perspective view for explaining the structure of a metal frame 312 according to a twelfth modification.
[FIG. 20]

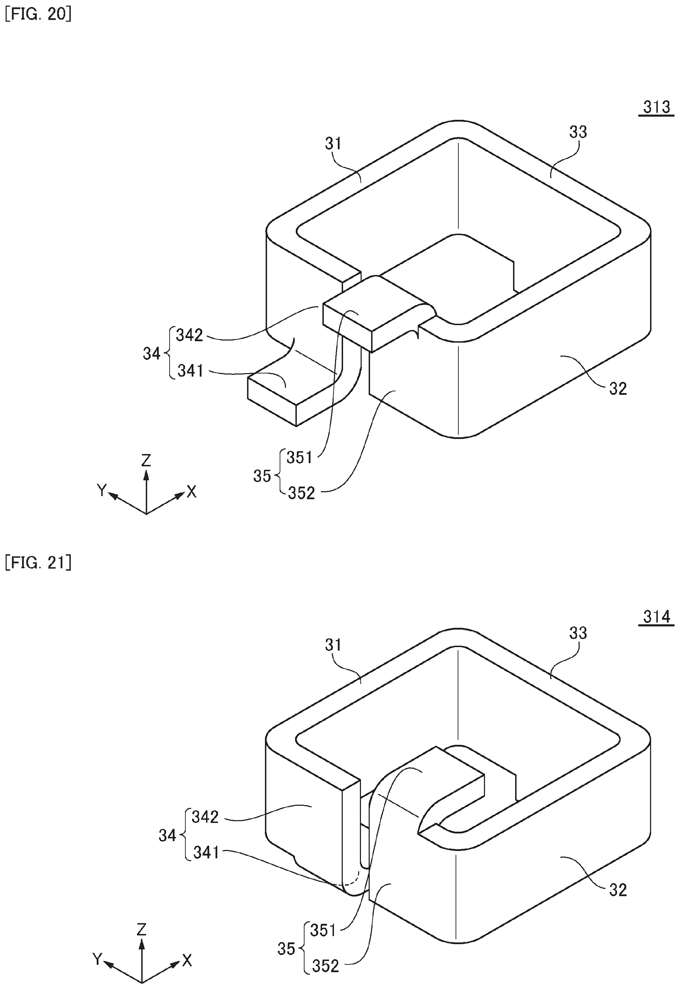

   FIG. 20 is a schematic perspective view for explaining the structure of a metal frame 313 according to a thirteenth modification.
[FIG. 21]
   FIG. 21 is a schematic perspective view for explaining the structure of a metal frame 314 according to a fourteenth modification.
[FIG. 22]

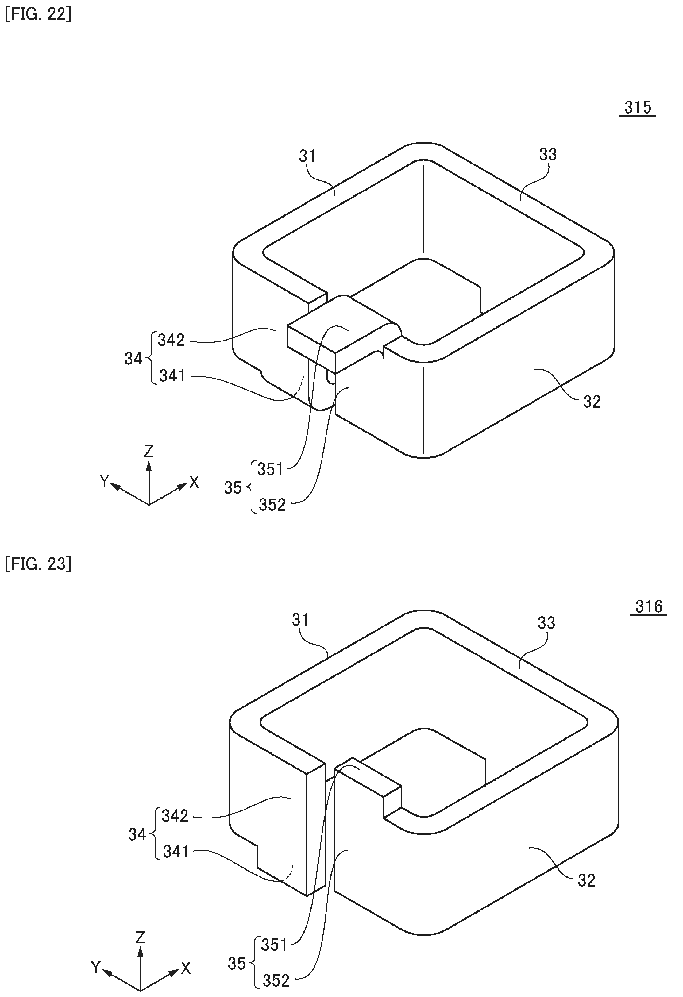

   FIG. 22 is a schematic perspective view for explaining the structure of a metal frame 315 according to a fifteenth modification.
[FIG. 23]
   FIG. 23 is a schematic perspective view for explaining the structure of a metal frame 316 according to a sixteenth modification.

### [Mode for Carrying Out the Invention]

Hereinafter, some embodiments of the technology described herein will be described in detail with reference to the accompanying drawings.

FIGS. 1(a) and 1(b) are schematic perspective views illustrating the external appearance of an electronic component 10 according to a first embodiment of the technology described herein, as seen from different directions. FIGS. 1(c) and 1(d) are schematic perspective views with transparency illustrating the electronic component 10, as seen from different directions. For ease of understanding, FIGS. 1(a) to 1(d) illustrate the X-, Y-, and Z-axes by way of example. Hereinafter, in each of the X-, Y-, and Z-axes, the direction in which the arrow points is referred to as "positive (+) direction", and its opposite direction is as "negative (-) direction" (the same applies to other drawings). In the present disclosure, the Z-, X-, and Y-directions are sometimes referred to as "first direction", "second direction", and "third direction", respectively.

The electronic component 10 according to the example illustrated in FIGS. 1(a) to 1(d) has a magnetic element body 20 and a metal frame 30 embedded in the magnetic element body 20. The magnetic element body 20 may be made of a composite magnetic material obtained by binding, with a resin binder, a magnetic filler made of a high-permeability material such as ferrite or permalloy. The magnetic element body 20 has main surfaces 21 and 22 constituting the XY plane and located on mutually opposite sides, side surfaces 23 and 24 constituting the YZ plane and located on mutually opposite sides, and side surfaces 25 and 26 constituting the XZ plane and located on mutually opposite sides.

The metal frame 30 is a member made of metal (e.g., copper (Cu)) and functions as a coil conductor. For example, the metal frame 30 may be manufactured by punching a flat metal sheet, followed by a bending process. In this case, the metal frame 30 may have a nearly uniform thickness throughout. Further, the metal frame 30 may be a seamless integral metal member. Thus, using the metal frame 30 as a coil conductor reduces DC resistance compared to a coil conductor made of plated film or similar materials. Therefore, the electronic component 10 according to the present embodiment can be suitably used also as an inductor for a power supply circuit.

FIG. 2 is a schematic perspective view for explaining the structure of the metal frame 30.

The metal frame 30 illustrated in FIG. 2 has substantially parallel flat-plate-shaped sections 31 and 32 each extending in the XY direction (with the Z-direction as the thickness direction), a flat-plate-shaped section 33 extending in the YZ direction (with the X-direction as the thickness direction) so as to connect the end portion of the section 31 in the positive X-direction and the end portion of the section 32 in the positive X-direction, a section 34 connected to the end portion of the section 31 in the negative X-direction, and a section 35 connected to the end portion of the section 32 in the negative X-direction. The sections 31 and 32 need not be strictly parallel, as long as they overlap each other in the Z-direction. Further, the section 33 need not be strictly perpendicular to the sections 31 and 32 and may have a certain degree of inclination (e.g., about ± 20° from the vertical).

As illustrated in FIGS. 1(c) and 1(d), the region of the magnetic element body 20 sandwiched between the sections 31 and 32 in the Z-direction constitutes an inner diameter region 27 of the coil conductor. The coil axis of the coil conductor formed of the metal frame 30 extends in the Y-direction and passes through the inner diameter region 27. The section 31 is located on the side closer to the main surface 22 than the inner diameter region 27. The XY surface, being a part of the section 31, may be exposed on the main surface 22, as illustrated in FIG. 1(a). The section 32 is located on the side closer to the main surface 21 than the inner diameter region 27. The XY surface, being a part of the section 32, may be exposed on the main surface 21, as illustrated in FIG. 1(b). It is not essential for a part of the section 31 and a part of the section 32 to be exposed on the surface of the magnetic element body 20; however, when they are exposed on the surface of the magnetic element body 20, heat generated by a current flowing through the metal frame 30 can be efficiently dissipated. On the other hand, the section 33 may be entirely embedded in the magnetic element body 20. In this case, the section 33 is not exposed on the surface of the magnetic element body 20. From the standpoint of improving heat dissipation, at least part of the section 33 may be exposed on the surface of the magnetic element body 20. This allows for a reduction in the size of the electronic component 10 in the X-direction. Further, the metal frame 30 may be configured so as not to be exposed on the surfaces 23 to 26.

The section 34 includes a terminal part 341 extending in the XY direction (with the Z-direction as the thickness direction) and at least partially exposed on the main surface 21 and a connection part 342 extending in the YZ direction (with the X-direction as the thickness direction) so as to connect the terminal part 341 and the end portion of the section 31 in the negative X-direction. The connection part 342 extends in the negative Z-direction from the section 31 toward the terminal part 341. The terminal part 341 extends in the negative X-direction from the boundary with the connection part 342. That is, the section 31 and the terminal part 341 are located on opposite sides of the connection part 342 in the X-direction. The connection part 342 need not be strictly perpendicular to the terminal part 341 and section 31 and may have a certain degree of inclination. As illustrated in FIG. 1(b), the XY surface, being a part of the terminal part 341, is exposed on the main surface 21 of the magnetic element body 20. The surface of the terminal part 341 exposed on the main surface 21 of the magnetic element body 20 constitutes one terminal electrode of the coil conductor. The surface of the terminal part 341 exposed on the main surface 21 of the magnetic element body 20 and the surface of the section 32 exposed on the main surface 21 of the magnetic element body 20 may be flush with each other.

The section 35 includes a terminal part 351 extending in the XY direction (with the Z-direction as the thickness direction) and at least partially exposed on the main surface 22 and a connection part 352 extending in the YZ direction (with the X-direction as the thickness direction) so as to connect the terminal part 351 and the end portion of the section 32 in the negative X-direction. The connection part 352 extends in the positive Z-direction from the section 32 toward the terminal part 351. The terminal part 351 extends in the negative X-direction from the boundary with the connection part 352. That is, the section 32 and the terminal part 351 are located on opposite sides of the connection part 352 in the X-direction. The connection part 352 need not be strictly perpendicular to the terminal part 351 and section 32 and may have a certain degree of inclination. As illustrated in FIG. 1(a), the XY surface, being a part of the terminal part 351, is exposed on the main surface 22 of the magnetic element body 20. The surface of the terminal part 351 exposed on the main surface 22 of the magnetic element body 20 constitutes the other terminal electrode of the coil conductor. The surface of the terminal part 351 exposed on the main surface 22 of the magnetic element body 20 and the surface of the section 31 exposed on the main surface 22 of the magnetic element body 20 may be flush with each other.

The terminal part 341 exposed on the main surface 21 of the magnetic element body 20 and the terminal part 351 exposed on the main surface 22 of the magnetic element body 20 differ in position in the Y-direction. Thus, in a plan view as seen from the Z-direction, the terminal parts 341 and 351 do not overlap each other. The terminal parts 341 and 351 may be situated in the same position in the X-direction. Alternatively, in a plan view as seen from the Z-direction, the terminal parts 341 and 351 may partially overlap each other. In this case, for example, at least a part of the terminal part 341 may be configured to extend in the positive Y-direction, or at least a part of the terminal part 351 may be configured to extend in the negative Y-direction.

The connection part 342 of the section 34 and the connection part 352 of the section 35 are arranged in the Y-direction. The connection parts 342 and 352 may be arranged such that the YZ surface of the connection part 342 that faces the section 33 and the YZ surface of the connection part 352 that faces the section 33 are flush with each other. Further, the connection parts 342 and 352 may be arranged such that the YZ surfaces of the connection parts 342 and 352, opposite to the surfaces facing the section 33, are flush with each other. The inner diameter region 27 of the magnetic element body 20 is sandwiched between the section 33 and the connection parts 342, 352 in the X-direction. That is, the inner diameter region 27 of the magnetic element body 20 is surrounded in both the X- and Z-directions by the metal frame 30 having its axis extending in the Y-direction.

With such a configuration, the metal frame 30 embedded in the magnetic element body 20 constitutes a coil conductor wound in about one turn. The terminal part 341 constituting one end of the coil conductor is exposed on one main surface (main surface 21) of the magnetic element body 20, and the terminal part 351 constituting the other end of the coil conductor is exposed on the other main surface (main surface 22) of the magnetic element body 20. Thus, unlike surface-mounted electronic components, the electronic component 10 allows the coil conductor to be connected from both sides (opposing main surfaces 21 and 22 of the magnetic element body 20) in the Z-direction. Thus, the electronic component 10 is, for example, suitable for being incorporated in a substrate and is easy to use.

The terminal part 341 extends outward (in the negative X-direction) from the connection part 342 via a bend, and the terminal part 351 extends outward (in the negative X-direction) from the connection part 352 via a bend, so that spacing between the terminal part 341 exposed on the main surface 21 and the section 32 is ensured, and spacing between the terminal part 351 exposed on the main surface 22 and the section 31 is ensured. This makes it possible to further improve the resistance to short circuits between the terminal part 341 and the section 32 and that between the terminal part 351 and the section 31.

FIG. 3 is a schematic cross-sectional view of an electronic component-embedded substrate 100 incorporating the electronic component 10 according to the present embodiment.

The electronic component-embedded substrate 100 according to the example of FIG. 3 includes a core layer 110 having a through hole 113, an insulating resin layer 121 provided on one main surface 111 of the core layer 110, and an insulating resin layer 122 provided on the other main surface 112 of the core layer 110. The core layer 110 is a high-strength insulating layer formed by impregnating a core material, such as glass cloth, with a resin material. On the other hand, the insulating resin layers 121 and 122 are each an insulating layer made of a resin material not containing a core material such as glass cloth and excellent in flexibility. The electronic component 10 according to the present embodiment is housed in the through hole 113 of the core layer 110 such that the main surface 21 of the magnetic element body 20 and the terminal part 341 are covered with the insulating resin layer 121 and that the main surface 22 of the magnetic element body 20 and the terminal part 351 are covered with the insulating resin layer 122.

Conductor layers L1 and L2 are formed on the front and back sides of the insulating resin layer 121. The conductor layer L1 is exposed on one surface of the electronic component-embedded substrate 100 and is partially covered with a solder resist 131. Of conductor patterns 141 to 144 located in the conductor layer L1, the portions not covered with the solder resist 131 constitute external terminals. The conductor pattern 141 located in the conductor layer L1 is connected to the terminal part 341 of the electronic component 10 through a via conductor 151 penetrating the insulating resin layer 121.

The conductor layer L2 is located between the insulating resin layer 121 and the core layer 110. In the example of FIG. 3, the conductor layer L2 includes conductor patterns 162 and 164. The conductor pattern 142 located in the conductor layer L1 is connected to the conductor pattern 162 located in the conductor layer L2 through a via conductor 152 penetrating the insulating resin layer 121. The conductor pattern 144 located in the conductor layer L1 is connected to the conductor pattern 164 located in the conductor layer L2 through a via conductor 154 penetrating the insulating resin layer 121.

Conductor layers L3 and L4 are formed on the front and back sides of the insulating resin layer 122. The conductor layer L4 is exposed on the other surface of the electronic component-embedded substrate 100 and is partially covered with a solder resist 132. Of conductor patterns 171 to 174 located in the conductor layer L4, the portions not covered with the solder resist 132 constitute external terminals. The conductor pattern 174 located in the conductor layer L4 is connected to the terminal part 351 of the electronic component 10 through a via conductor 184 penetrating the insulating resin layer 122.

The conductor layer L3 is located between the insulating resin layer 122 and the core layer 110. In the example of FIG. 3, the conductor layer L3 includes conductor patterns 191 and 193. The conductor pattern 171 located in the conductor layer L4 is connected to the conductor pattern 191 located in the conductor layer L3 through a via conductor 181 penetrating the insulating resin layer 122. The conductor pattern 173 located in the conductor layer L4 is connected to the conductor pattern 193 located in the conductor layer L3 through a via conductor 183 penetrating the insulating resin layer 122.

The core layer 110 may have a plurality of through hole conductors including through hole conductors TH1 and TH2 formed therein. These through hole conductors all penetrate the core layer 110 to connect the conductor patterns located in the conductor layer L2 and the conductor patterns located in the conductor layer L3. In the example of FIG. 3, the conductor pattern 162 located in the conductor layer L2 and the conductor pattern 191 located in the conductor layer L3 are connected to each other through the through hole conductor TH1, and the conductor pattern 164 located in the conductor layer L2 and the conductor pattern 193 located in the conductor layer L3 are connected to each other through the through hole conductor TH2.

In the example illustrated in FIG. 3, the insulating resin layer 121 is larger in thickness than the insulating resin layer 122. Further, in the example of FIG. 3, the thickness of the electronic component 10 in the Z-direction is larger than the thickness of the core layer 110 in the Z-direction and, accordingly, the main surface 21 of the magnetic element body 20 of the electronic component 10 protrudes from the main surface 111 of the core layer 110. On the other hand, the main surface 22 of the magnetic element body 20 of the electronic component 10 may be flush with the main surface 112 of the core layer 110. This reduces the film thickness of the insulating resin layer 121 at the portion covering the terminal part 341, thus improving the machining accuracy of the via that exposes the terminal part 341.

FIG. 4(a) is a schematic perspective view with transparency illustrating the outer appearance of an electronic component 10A according to a second embodiment of the technology described herein. FIG. 4(b) is a schematic top view with transparency of the electronic component 10A.

The electronic component 10A illustrated in FIGS. 4(a) and 4(b) differs from the electronic component 10 according to the first embodiment in that a magnetic core 28 is inserted through the inner diameter region 27 surrounded by the metal frame 30. Other basic configurations may be the same as those of the electronic component 10 according to the first embodiment, so the same reference numerals are given to the same elements, and overlapping description will be omitted.

The magnetic core 28 is made of a material with higher permeability than the magnetic element body 20. When such a magnetic core 28 is inserted through the inner diameter region 27, it becomes possible to increase the inductance of the coil conductor constituted by the metal frame 30. For example, as illustrated in the embodiment of FIGS. 4(a) and 4(b), the magnetic core 28 may be formed in such a size and shape that a part thereof protrudes from the inner diameter region 27 of the metal frame 30. However, the invention is not limited thereto, and the magnetic core 28 may be formed in a size and shape that fits within the inner diameter region 27 of the metal frame 30, for example.

FIG. 5(a) is a schematic perspective view with transparency illustrating the outer appearance of an electronic component 10B according to a third embodiment of the technology described herein. FIG. 5(b) is a schematic top view with transparency of the electronic component 10B.

The electronic component 10B illustrated in FIGS. 5(a) and 5(b) differs from the electronic component 10 according to the first embodiment in that a metal frame 30B is additionally embedded in the magnetic element body 20. Other basic configurations may be the same as those of the electronic component 10 according to the first embodiment, so the same reference numerals are given to the same elements, and overlapping description will be omitted. Reference numerals for elements constituting the metal frame 30B are given by appending "B" to those of the corresponding elements of the metal frame 30.

In the example of FIGS. 5(a) and 5(b), the metal frame 30B is formed in substantially the same shape as the above-described metal frame 30. The metal frames 30 and 30B are arranged in the Y-direction inside the magnetic element body 20. The metal frame 30B is embedded in the magnetic element body 20 coaxially with the metal frame 30 in a state where the metal frame 30 is rotated 180° about the coil axis extending in the Y-direction. This allows two coil conductors to be embedded in one electronic component. Further, three or more coil conductors may be embedded in one electronic component.

In the example of FIGS. 5(a) and 5(b), the connection parts 342, 352 of the metal frame 30 and a section 33B of the metal frame 30B are located at substantially the same position in the X-direction, and the section 33 of the metal frame 30 and the connection parts 342B, 352B of the metal frame 30B are located at substantially the same position in the X-direction.

If, in actual use of the electronic component 10B according to the present embodiment, current flows from the terminal part 351 to the terminal part 341 in the metal frame 30 and from a termina part 341B to a terminal part 351B in the metal frame 30B, mutual cancellation of magnetic fields generated by the metal frames 30 and 30B is reduced, resulting in increased inductance. That is, as illustrated in FIG. 6, if current flows from the terminal part 351 to the terminal part 341 of the metal frame 30, current flows through the connection parts 342 and 352 in the negative Z-direction and through the section 33 in the positive Z-direction. On the other hand, if current flows from the terminal part 341B to the terminal part 351B of the metal frame 30B, current flows through the connection parts 342B and 352B in the negative Z-direction and through the section 33B in the positive Z-direction. As a result, in the region denoted by B1, the magnetic field generated by the connection parts 342 and 352 coincides in direction with the magnetic field generated by the section 33B, with the result that the magnetic fields in the region B1 can reinforce each other. Similarly, in the region denoted by B2, the magnetic field generated by the connection parts 342B and 352B coincides in direction with the magnetic field generated by the section 33, with the result that the magnetic fields in the region B2 can reinforce each other.

FIG. 7(a) is a schematic perspective view with transparency illustrating the outer appearance of an electronic component 10C according to a fourth embodiment of the technology described herein. FIG. 7(b) is a schematic top view with transparency of the electronic component 10C.

The electronic component 10C illustrated in FIGS. 7(a) and 7(b) differs from the electronic component 10B according to the third embodiment in that the magnetic core 28 extends continuously through the inner diameter region 27 surrounded by the metal frame 30 and an inner diameter region 27B surrounded by the metal frame 30B. Other basic configurations may be the same as those of the electronic component 10B according to the third embodiment, so the same reference numerals are given to the same elements, and overlapping description will be omitted.

The magnetic core 28 is made of a material with higher permeability than the magnetic element body 20 and has a shape that continuously penetrates through the inner diameter region 27 surrounded by the metal frame 30 and the inner diameter region 27B surrounded by the metal frame 30B. As described above, even when a plurality of metal frames are embedded in the magnetic element body 20, a common magnetic core (in this case, magnetic core 28) can be used. This makes it possible to reduce the number of components.

FIG. 8 is a schematic perspective view for explaining the structure of a metal frame 301 according to a first modification.

The metal frame 301 illustrated in FIG. 8 differs from the metal frame 30 illustrated in FIG. 2 in that the widths of the terminal parts 341 and 351 in the Y-direction are enlarged. Other basic configurations may be the same as those of the metal frame 30 illustrated in FIG. 2, so the same reference numerals are given to the same elements, and overlapping description will be omitted.

In the example illustrated in FIG. 8, the widths of the connection parts 342 and 352 in the Y-direction are W2, while the widths of the terminal parts 341 and 351 in the Y-direction are W1 (> W2). The terminal part 341 is enlarged in width in the negative Y-direction, and thus the enlarged part does not interfere with the connection part 352. Similarly, the terminal part 351 is enlarged in width in the positive Y-direction, and thus the enlarged part does not interfere with the connection part 342. By thus enlarging the widths of the terminal parts 341 and 351 in the Y-direction, the exposed areas of the termina parts 341 and 351 from the magnetic element body 20 are enlarged correspondingly, thus increasing connection reliability.

FIG. 9(a) is a schematic perspective view for explaining the structure of a metal frame 302 according to a second modification.

The metal frame 302 illustrated in FIG. 9(a) differs from the metal frame 30 illustrated in FIG. 2 in that the terminal part 341 extends in the positive X-direction from the connection part 342 via a bend and that the terminal part 351 extends in the positive X-direction from the connection part 352 via a bend. Other basic configurations may be the same as those of the metal frame 30 illustrated in FIG. 2, so the same reference numerals are given to the same elements, and overlapping description will be omitted.

In the example illustrated in FIG. 9(a), the terminal part 341 and a part of the section 31 face each other in the Z-direction through the inner diameter region 27, and the terminal part 351 and a part of the section 32 face each other in the Z-direction through the inner diameter region 27. By thus bending the sections 34 and 35 inward (in the positive X-direction) to respectively form the terminal parts 341 and 351, the size of the metal frame 30 in the X-direction can be reduced. Further, like a metal frame 302A illustrated in FIG. 9(b), the widths of the thus formed terminal parts 341 and 351 may be enlarged in the Y-direction.

FIG. 10(a) is a schematic perspective view for explaining the structure of a metal frame 303 according to a third modification.

The metal frame 303 illustrated in FIG. 10(a) differs from the metal frame 30 illustrated in FIG. 2 in that the terminal part 351 extends in the positive X-direction from the connection part 352 via a bend. Other basic configurations may be the same as those of the metal frame 30 illustrated in FIG. 2, so the same reference numerals are given to the same elements, and overlapping description will be omitted.

In the example illustrated in FIG. 10(a), the terminal part 351 and a part of the section 32 face each other in the Z-direction through the inner diameter region 27. On the other hand, the terminal part 341 extends in the negative X-direction (outward) from the connection part 342 via a bend as in the metal frame 30 illustrated in FIG. 2. Thus, one of the terminal parts 341 and 351 may be configured to extend inward via a bend, and the other outward. Further, like a metal frame 303A illustrated in FIG. 10(b), the widths of the thus formed terminal parts 341 and 351 may be enlarged in the Y-direction.

FIG. 11(a) is a schematic perspective view for explaining the structure of a metal frame 304 according to a fourth modification.

The metal frame 304 illustrated in FIG. 11(a) differs from the metal frame 30 illustrated in FIG. 2 in that the terminal parts 341 and 351 are not formed so as to extend in the X-direction via bends but are constituted by the XY surfaces at the leading ends of the connection parts 342 and 352. Other basic configurations may be the same as those of the metal frame 30 illustrated in FIG. 2, so the same reference numerals are given to the same elements, and overlapping description will be omitted. Thus, it is not essential for the terminal parts 341 and 351 to be portions obtained by bending the sections 34 and 35 so as to extend from the connection parts 342 and 352 via bends. Further, like a metal frame 304A illustrated in FIG. 11(b), the areas of the terminal parts 341 and 351 as the exposed surfaces may be enlarged by enlarging the widths of the connection parts 342 and 352 in the Y-direction.

FIG. 12(a) is a schematic perspective view for explaining the structure of a metal frame 305 according to a fifth modification.

The metal frame 305 illustrated in FIG. 12(a) differs from the metal frame 30 illustrated in FIG. 2 in that the connection parts 342 and 352 extend in the X- and Z-directions (with the Y-direction as the thickness direction) and face each other in the Y-direction through the inner diameter region 27. Other basic configurations may be the same as those of the metal frame 30 illustrated in FIG. 2, so the same reference numerals are given to the same elements, and overlapping description will be omitted.

In the example illustrated in FIG. 12(a), the terminal part 341 extends in the negative Y-direction from the connection part 342 via a bend, and the terminal part 351 extends in the positive Y-direction from the connection part 352 via a bend. This can ensure sufficient areas of the sections 31 and 32. Further, like a metal frame 305A illustrated in FIG. 12(b), the widths of the thus formed terminal parts 341 and 351 may be enlarged in the X-direction.

FIG. 13(a) is a schematic perspective view for explaining the structure of a metal frame 306 according to a sixth modification.

The metal frame 306 illustrated in FIG. 13(a) differs from the metal frame 305 illustrated in FIG. 13(a) in that the terminal part 341 extends in the positive Y-direction from the connection part 342 via a bend and that the terminal part 351 extends in the negative Y-direction from the connection part 352 via a bend. Other basic configurations may be the same as those of the metal frame 305 illustrated in FIG. 13(a), so the same reference numerals are given to the same elements, and overlapping description will be omitted.

In the example illustrated in FIG. 13(a), the terminal part 341 and a part of the section 31 face each other in the Z-direction through the inner diameter region 27, and the terminal part 351 and a part of the section 32 face each other in the Z-direction through the inner diameter region 27. By thus bending the section 34 inward (in the positive Y-direction) to form the terminal part 341 and the section 35 inward (in the negative Y-direction) to form the terminal part 351, the size of the metal frame 30 in the Y-direction can be reduced. Further, like a metal frame 306A illustrated in FIG. 13(b), the widths of the thus formed terminal parts 341 and 351 may be enlarged in the X-direction.

FIG. 14(a) is a schematic perspective view for explaining the structure of a metal frame 307 according to a seventh modification.

The metal frame 307 illustrated in FIG. 14(a) differs from the metal frame 305 illustrated in FIG. 12(a) in that the terminal part 351 extends in the negative Y-direction from the connection part 352 via a bend. Other basic configurations may be the same as those of the metal frame 305 illustrated in FIG. 12(a), so the same reference numerals are given to the same elements, and overlapping description will be omitted.

In the example illustrated in FIG. 14(a), the terminal part 351 and a part of the section 32 face each other in the Z-direction through the inner diameter region 27. The terminal part 341 extends in the negative Y-direction (outward) from the connection part 342 via a bend as in the metal frame 305 illustrated in FIG 12(a). Thus, one of the terminal parts 341 and 351 may be configured to extend inward via a bend, and the other outward. Further, like a metal frame 307A illustrated in FIG. 14(b), the widths of the thus formed terminal parts 341 and 351 may be enlarged in the X-direction.

FIG. 15(a) is a schematic perspective view for explaining the structure of a metal frame 308 according to an eighth modification.

The metal frame 308 illustrated in FIG. 15(a) differs from the metal frame 305 illustrated in FIG. 12(a) in that the terminal parts 341 and 351 are not formed so as to extend in the Y-direction via a bend but are constituted by the XY surfaces at the leading ends of the connection parts 342 and 352. Other basic configurations may be the same as those of the metal frame 305 illustrated in FIG. 12(a), so the same reference numerals are given to the same elements, and overlapping description will be omitted. Thus, it is not essential for the terminal parts 341 and 351 to be portions obtained by bending the sections 34 and 35 so as to extend from the connection parts 342 and 352 via bends. Further, like a metal frame 308A illustrated in FIG. 15(b), the areas of the terminal parts 341 and 351 as the exposed surfaces may be enlarged by enlarging the widths of the connection parts 342 and 352 in the X-direction.

FIG. 16 is a schematic perspective view for explaining the structure of a metal frame 309 according to a ninth modification.

The metal frame 309 illustrated in FIG. 16 has substantially parallel sections 31 and 32 both extending in the X- and Z-directions (with the Y-direction as the thickness direction), a section 33 connecting the end portion of the section 31 in the positive X-direction and the end portion of the section 32 in the positive X-direction and extending in the Y- and Z-directions (with the X-direction as the thickness direction), a section 34 connected to the end portion of the section 31 in the negative X-direction, and a section 35 connected to the end portion of the section 32 in the negative X-direction.

The region of the magnetic element body 20 sandwiched between the sections 31 and 32 in the Y-direction constitutes the inner diameter region 27 of the coil conductor. The coil axis of the coil conductor formed of the metal frame 309 extends in the Z-direction and passes through the inner diameter region 27. The section 31 is located on the side closer to the side surface 26 than the inner diameter region 27. The section 32 is located on the side closer to the side surface 25 than the inner diameter region 27. The section 34 is a portion extending in the positive Y-direction (outward) from the section 31 via a bend, and the surface thereof is exposed on the main surface 21 of the magnetic element body 20. The section 35 is a portion extending in the negative Y-direction (outward) from the section 32 via a bend, and the surface thereof is exposed on the main surface 22 of the magnetic element body 20.

As exemplified by the metal frame 309 of FIG. 16, the coil conductor formed of the metal frame may have its axis extending in the Z-direction. Further, the section 34 need not include the terminal part 341 and connection part 342, but the portion extending from the section 31 via a bend may be directly exposed on the main surface 21 of the magnetic element body 20. Similarly, the section 35 need not include the terminal part 351 and connection part 352, but the portion extending from the section 32 via a bend may be directly exposed on the main surface 22 of the magnetic element body 20.

FIG. 17 is a schematic perspective view for explaining the structure of a metal frame 310 according to a tenth modification.

The metal frame 310 illustrated in FIG. 17 differs from the metal frame 309 illustrated in FIG. 16 in that the section 34 extends in the negative Y-direction from the section 31 via a bend and that the section 35 extends in the positive Y-direction from the section 32 via a bend. Other basic configurations may be the same as those of the metal frame 309 illustrated in FIG. 16, so the same reference numerals are given to the same elements, and overlapping description will be omitted.

In the example illustrated in FIG. 17, the sections 34 and 35 have portions that face each other in the Z-direction through the inner diameter region 27. By thus configuring the section 34 to extend inward (in the negative Y-direction) via a bend and the section 35 to extend inward (in the positive Y-direction) via a bend, the size of the metal frame 310 in the Y-direction can be reduced.

FIG. 18 is a schematic perspective view for explaining the structure of a metal frame 311 according to an eleventh modification.

The metal frame 311 illustrated in FIG. 18 differs from the metal frame 309 illustrated in FIG. 16 in that the section 34 extends in the negative Y-direction from the section 31 via a bend. Other basic configurations may be the same as those of the metal frame 309 illustrated in FIG. 16, so the same reference numerals are given to the same elements, and overlapping description will be omitted. The section 35 extends in the negative Y-direction (outward) from the section 32 via a bend as in the metal frame 309 illustrated in FIG. 16. Thus, one of the sections 34 and 35 may be configured to extend inward via a bend, and the other outward.

FIG. 19 is a schematic perspective view for explaining the structure of a metal frame 312 according to a twelfth modification.

The metal frame 312 illustrated in FIG. 19 differs from the metal frame 309 illustrated in FIG. 16 in that the sections 34 and 35 are not formed so as to extend in the X-direction via a bend but are constituted by the XY surfaces at the leading ends of the sections 31 and 32. Other basic configurations may be the same as those of the metal frame 309 illustrated in FIG. 16, so the same reference numerals are given to the same elements, and overlapping description will be omitted. Thus, it is not essential for the sections 34 and 35 to be portions respectively extending from the sections 31 and 32 via bends.

FIG. 20 is a schematic perspective view for explaining the structure of a metal frame 313 according to a thirteenth modification.

The metal frame 313 illustrated in FIG. 20 differs from the metal frame 309 illustrated in FIG. 16 in that the section 34 includes a terminal part 341 and a connection part 342, that the section 35 includes a terminal part 351 and a connection part 352, that the connection pats 342 and 352 extend in the Y- and Z-directions (with the X-direction as the thickness direction), and that the terminal pats 341 and 351 extend in the X- and Y-directions (with the Z-direction as the thickness direction). Other basic configurations may be the same as those of the metal frame 309 illustrated in FIG. 16, so the same reference numerals are given to the same elements, and overlapping description will be omitted.

In the example illustrated in FIG. 20, the connection part 342 extends in the negative Y-direction from the section 31 via a bend, and the connection part 352 extends from the section 32 in the positive Y-direction via a bend. As a result, the section 33 and connection parts 342, 352 face each other in the inner diameter region 27. The terminal part 341 extends in the negative X-direction (outward) from the connection part 342 via a bend, and the terminal part 351 extends in the negative X-direction (outward) from the connection part 352 via a bend. With such a configuration, it is possible to obtain a larger inductance than that in the metal frame 309 illustrated in FIG. 16.

FIG. 21 is a schematic perspective view for explaining the structure of a metal frame 314 according to a fourteenth modification.

The metal frame 314 illustrated in FIG. 21 differs from the metal frame 313 illustrated in FIG. 20 in that the terminal part 341 extends in the positive X-direction (inward) from the connection part 342 via a bend, and the terminal part 351 extends in the positive X-direction (inward) from the connection part 352 via a bend. Other basic configurations may be the same as those of the metal frame 313 illustrated in FIG. 20, so the same reference numerals are given to the same elements, and overlapping description will be omitted. Thus, by thus configuring the terminal parts 341 and 352 to extend inward (in the positive X-direction) via a bend, it is possible to reduce the size of the metal frame 314 in the X-direction.

FIG. 22 is a schematic perspective view for explaining the structure of a metal frame 315 according to a fifteenth modification.

The metal frame 315 illustrated in FIG. 22 differs from the metal frame 313 illustrated in FIG. 20 in that the terminal part 341 extends in the positive X-direction (inward) from the connection part 342 via a bend. Other basic configurations may be the same as those of the metal frame 313 illustrated in FIG. 20, so the same reference numerals are given to the same elements, and overlapping description will be omitted. The terminal part 351 extends in the negative X-direction (outward) from the connection part 352 via a bend as in the metal frame 313 illustrated in FIG. 20. Thus, one of the terminal parts 341 and 351 may be configured to extend inward via a bend, and the other outward.

FIG. 23 is a schematic perspective view for explaining the structure of a metal frame 316 according to a sixteenth modification.

The metal frame 316 illustrated in FIG. 23 differs from the metal frame 313 illustrated in FIG. 20 in that the terminal parts 341 and 351 are not formed so as to extend in the X-direction via bends but are constituted by the XY surfaces at the leading ends of the connection parts 342 and 352. Other basic configurations may be the same as those of the metal frame 313 illustrated in FIG. 20, so the same reference numerals are given to the same elements, and overlapping description will be omitted. Thus, it is not essential for the terminal parts 341 and 351 to be portions respectively extending from the connection parts 342 and 352 via bends.

While some embodiment of the present disclosure has been described, the technology according to the present disclosure is not limited to the above embodiment, and various modifications may be made within the scope of the present disclosure, and all such modifications are included in the present disclosure.

The present disclosure also encompasses embodiments resulting from appropriate combinations of the above-described embodiments and modifications.

For example, the electronic component 10B may be formed by combining and arranging the electronic component 10 according to the first embodiment and electronic component 10A according to the second embodiment. That is, in this case, the magnetic core 28 is inserted through the inner diameter region 27 of at least one of the two or more metal frames.

Further, for example, the metal frame 301 according to the first modification illustrated in FIG. 8 may be used as the metal frames according to the second to fourth embodiments. Similarly, for example, the metal frame 302 (302A) according to the second modification illustrated in FIGS. 9(a) and 9(b), the metal frame 303 (303A) according to the third modification illustrated in FIGS. 10(a) and 10(b), the metal frame 304 (304A) according to the fourth modification illustrated in FIGS. 11(a) and 11(b), the metal frame 305 (305A) according to the fifth modification illustrated in FIGS. 12(a) and 12(b), the metal frame 306 (306A) according to the sixth modification illustrated in FIGS. 13(a) and 13(b), the metal frame 307 (307A) according to the seventh modification illustrated in FIGS. 14(a) and 14(b), and the metal frame 308 (308A) according to the eighth modification illustrated in FIGS. 15(a) and 15(b) may be used as the metal frames according to the second to fourth embodiments.

Further, for example, the metal frame 309 according to the ninth modification illustrated in FIG. 16 may be used as the metal frame according to the second or third embodiment. When the metal frame 309 is used as the metal frame according to the second embodiment, the magnetic core 28 may be formed in a size and shape that fits within the inner diameter region 27 of the metal frame 30. Further, an electronic component of a type similar to the third or fourth embodiment may be formed by arranging one or more metal frames 309 having the magnetic core 28 inserted through the inner diameter region thereof. Similarly, for example, the metal frame 310 according to the tenth modification illustrated in FIG. 17, the metal frame 311 according to the eleventh modification illustrated in FIG. 18, the metal frame 312 according to the twelfth modification illustrated in FIG. 19, the metal frame 313 according to the thirteenth modification illustrated in FIG. 20, the metal frame 314 according to the fourteenth modification illustrated in FIG. 21, the metal frame 315 according to the fifteenth modification illustrated in FIG. 22, and the metal frame 316 according to the sixteenth modification illustrated in FIG. 23 may be used as the metal frame according to the second or third embodiment. When the metal frames according to these modifications are used as the metal frame according to the second embodiment, the magnetic core 28 may be formed in a size and shape that fits within the inner diameter region 27 of the metal frame 30. Further, an electronic component of a type similar to the third or fourth embodiment may be formed by arranging one or more metal frames having the magnetic core 28 inserted through the inner diameter region thereof.

Further, an electronic component of a type similar to the third or fourth embodiment may be formed by combining one or more metal frames 30 illustrated in FIG. 2 with one or more metal frames according to respective modifications, or by combining a plurality of metal frames according to the respective modifications.

The technology according to the present disclosure includes the following configuration examples but not limited thereto.

An electronic component according to an aspect of the present disclosure includes: a magnetic element body having a first main surface and a second main surface located on the opposite side of the first main surface; and a first metal frame embedded in the magnetic element body, wherein the first metal frame includes: first and second sections facing each other and substantially parallel to each other; a third section connecting one end of the first section and one end of the second section; a fourth section connected to the other end of the first section and exposed at least partially on the first main surface; and a fifth section connected to the other end of the second section and exposed at least partially on the second main surface. With this configuration, one end and the other end of a coil conductor formed of the first metal frame can be exposed on both the front and back sides of the magnetic element body.

In the above electronic component, the first section and the second section may face each other in a first direction, the magnetic element body may include an inner diameter region sandwiched between the first section and the second section in the first direction, the first section may be located on the side closer to the second main surface than the inner diameter region, the second section may be located on the side closer to the first main surface than the inner diameter region, the fourth section may include a first terminal part exposed at least partially on the first main surface and a first connection part connecting the first terminal part and the other end of the first section, and the fifth section may include a second terminal part exposed at least partially on the second main surface and a second connection part connecting the second terminal part and the other end of the second section. This can ensure sufficient sectional areas of the first and second sections even with a reduction in the height dimension of the electronic component, making it possible to reduce DC resistance.

In the above electronic component, the third section may face the first connection part and the second connection part in a second direction perpendicular to the first direction, and the inner diameter region may be sandwiched between the third section and the first connection part and the second connection part in the second direction. This makes it possible to obtain a larger inductance. In this case, at least the first section, the second section, the third section, the first connection part, and the second connection part of the first metal frame may constitute a coil, and the second direction may be perpendicular to the axial direction of the coil. This prevents the magnetic field generated by the first metal frame from interfering with the first and second connection parts.

In the above electronic component, the first connection part and the second connection part may face each other in a third direction perpendicular to the first direction, and the inner diameter region may be sandwiched between the first connection part and the second connection part in the third direction. This makes it possible to obtain a larger inductance. In this case, at least the first section, the second section, and the third section of the first metal coil may constitute a coil, and the third direction may be parallel to the axial direction of the coil. This can reduce the size of the first metal frame in the third direction perpendicular to the first and second directions.

In the above electronic component, a part of the first section may be exposed on the second main surface, and a part of the second section may be exposed on the first main surface. This can improve heat dissipation characteristics.

In the above electronic component, at least the first section, the second section, the third section, the first connection part, and the second connection part of the first metal frame may constitute a coil, and the axial direction of the coil may be perpendicular to the first main surface and the second main surface. This facilitates a reduction in the height dimension of the electronic component. In this case, the first section and the second section may face each other in a third direction, the magnetic element body may include an inner diameter region sandwiched between the first section and the second section in the third direction, the fourth section may include a first terminal part exposed at least partially on the first main surface and a first connection part connecting the first terminal part and the other end of the first section, the fifth section may include a second terminal part exposed at least partially on the second main surface and a second connection part connecting the second terminal part and the other end of the second section, and the inner diameter region may be sandwiched between the third section and the first and second connection parts in a second direction perpendicular to the third direction. This makes it possible to obtain a larger inductance.

The above electronic component may further include a magnetic core disposed in the inner diameter region sandwiched between the first section and the second section and having higher permeability than that of the magnetic element body. This makes it possible to obtain a larger inductance.

The above electronic component may further include a second metal frame having the same shape as the first metal frame, and the first frame and the second frame may be coaxially embedded in the magnetic element body.

An electronic component-embedded substrate according to an aspect of the present disclosure includes: a core layer in which the above-described electronic component is embedded; a first conductor pattern covering one main surface of the core layer and connected to the fourth section exposed on the magnetic element body; and a second conductor pattern covering the other main surface of the core layer and connected to the fifth section exposed on the magnetic element body. With this configuration, it is possible to configure a power supply circuit that incorporates an inductor by providing a switching circuit on the electronic component-embedded substrate.

This application claims the benefit of Japanese Patent Application No. 2023-151451, filed on September 19, 2023, the entire disclosure of which is incorporated by reference herein.

### [Reference Signs List]

10, 10A-10C electronic component
20 magnetic element body
21 main surface of magnetic element body (first surface)
22 main surface of magnetic element body (second surface)
23-26 side surface of magnetic element body
27, 27B inner diameter region
28 magnetic core
30, 30B, 301-316, 302A-308A metal frame
31 section of metal frame (first section)
32 section of metal frame (second section)
33, 33B section of metal frame (third section)
34 section of metal frame (fourth section)
35 section of metal frame (fifth section)
100 electronic component-embedded substrate
110 core layer
111 one main surface of core layer
112 other main surface of core layer
113 through hole
121, 122 insulating resin layer
131, 132 solder resist
141-144, 162, 164, 171-174,191,193 conductor pattern
151, 152, 154, 181, 183, 184 via conductor
341, 351 terminal part
342, 352, 342B, 352B connection part
B1, B2 region
L1-L4 conductor layer
TH1, TH2 through hole conductor

## Claims

1. An electronic component comprising:
a magnetic element body having a first main surface and a second main surface located on an opposite side of the first main surface; and
a first metal frame embedded in the magnetic element body,
wherein the first metal frame includes: first and second sections facing each other and substantially parallel to each other; a third section connecting one end of the first section and one end of the second section; a fourth section connected to other end of the first section and exposed at least partially on the first main surface; and a fifth section connected to other end of the second section and exposed at least partially on the second main surface.

2. The electronic component as claimed in claim 1,
wherein the first section and the second section face each other in a first direction,
wherein the magnetic element body includes an inner diameter region sandwiched between the first section and the second section in the first direction,
wherein the first section is located on a side closer to the second main surface than the inner diameter region,
wherein the second section is located on a side closer to the first main surface than the inner diameter region,
wherein the fourth section includes a first terminal part exposed at least partially on the first main surface and a first connection part connecting the first terminal part and the other end of the first section, and
wherein the fifth section includes a second terminal part exposed at least partially on the second main surface and a second connection part connecting the second terminal part and the other end of the second section.

3. The electronic component as claimed in claim 2,
wherein the third section faces the first connection part and the second connection part in a second direction perpendicular to the first direction, and
wherein the inner diameter region is sandwiched between the third section and the first connection part and the second connection part in the second direction.

4. The electronic component as claimed in claim 3,
wherein at least the first section, the second section, the third section, the first connection part, and the second connection part of the first metal frame constitute a coil, and
wherein the second direction is perpendicular to an axial direction of the coil.

5. The electronic component as claimed in claim 2,
wherein the first connection part and the second connection part face each other in a third direction perpendicular to the first direction, and
wherein the inner diameter region is sandwiched between the first connection part and the second connection parts in the third direction.

6. The electronic component as claimed in claim 5,
wherein at least the first section, the second section, and the third section of the first metal coil constitute a coil, and
wherein the third direction is parallel to an axial direction of the coil.

7. The electronic component as claimed in claim 1,
wherein a part of the first section is exposed on the second main surface, and
wherein a part of the second section is exposed on the first main surface.

8. The electronic component as claimed in claim 1,
wherein at least the first section, the second section, the third section, the first connection part, and the second connection part of the first metal frame constitute a coil, and
wherein an axial direction of the coil is perpendicular to the first main surface and the second main surface.

9. The electronic component as claimed in claim 8,
wherein the first section and the second section face each other in a third direction,
wherein the magnetic element body includes an inner diameter region sandwiched between the first section and the second section in the third direction,
wherein the fourth section includes a first terminal part exposed at least partially on the first main surface and a first connection part connecting the first terminal part and the other end of the first section,
wherein the fifth section includes a second terminal part exposed at least partially on the second main surface and a second connection part connecting the second terminal part and the other end of the second section, and
wherein the inner diameter region is sandwiched between the third section and the first and second connection parts in a second direction perpendicular to the third direction.

10. The electronic component as claimed in claim 1, further comprising a magnetic core disposed in an inner diameter region sandwiched between the first section and the second section and having higher permeability than that of the magnetic element body.

11. The electronic component as claimed in claim 1, further comprising a second metal frame having a same shape as the first metal frame,
wherein the first frame and the second frame are coaxially embedded in the magnetic element body.

12. An electronic component-embedded substrate comprising:
a core layer in which the electronic component as claimed in any one of claims 1 to 11 is embedded;
a first conductor pattern covering one main surface of the core layer and connected to the fourth section exposed on the magnetic element body; and
a second conductor pattern covering other main surface of the core layer and connected to the fifth section exposed on the magnetic element body.
